(19) Europäisches Patentamt
European Patent Office
Office européen des brevets

(11) EP 2 421 046 A1

(12) EUROPEAN PATENT APPLICATION

(43) Date of publication:
22.02.2012 Bulletin 2012/08

(51) Int Cl.:
*H01L 29/78* (2006.01)      *H01L 29/40* (2006.01)
*H01L 29/06* (2006.01)      *H01L 29/10* (2006.01)

(21) Application number: 10172930.9

(22) Date of filing: 16.08.2010

(84) Designated Contracting States:
AL AT BE BG CH CY CZ DE DK EE ES FI FR GB
GR HR HU IE IS IT LI LT LU LV MC MK MT NL NO
PL PT RO SE SI SK SM TR
Designated Extension States:
BA ME RS

(71) Applicant: NXP B.V.
5656 AG Eindhoven (NL)

(72) Inventors:
• Peake, Simon Thomas
Redhill, Surrey RH1 1DL (GB)

• Rutter, Phil
Redhill, Surrey RH1 1DL (GB)

(74) Representative: Hardingham, Christopher Mark
NXP Semiconductors
IP Department
Betchworth House
57-65 Station Road
Redhill,
Surrey RH1 1DL (GB)

(54) **MOSFET having a capacitance control region**

(57)      A MOSFET comprising a semiconductor substrate (1), an active region (2) of the semiconductor substrate (1) having a FET with gate (32), source (31) and drain (38) and a gate pad (8) electrically connected to the gate (32). The MOSFET further comprises a capacitance control region (6) having a plurality of insulated trenches extending into the semiconductor substrate (1) and containing conductive material (16) extending under the gate pad (8) and being electrically connected to the source (31) for providing additional capacitance between the source (31) and the gate (32) in order to minimise the effects of gate bounce.

Fig. 3

**Description**

The invention relates to a Trench MOS and a method of making it.

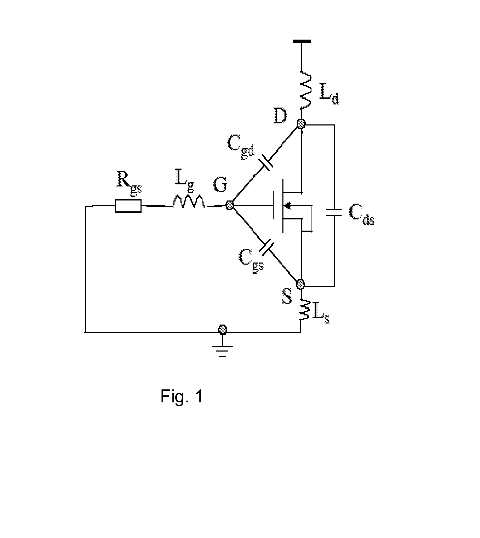

The equivalent circuit of a Metal Oxide Semiconductor Field Effect Transistor (MOSFET) is shown in Figure 1. Note that the capacitances between source, gate and drain are shown, as well as inductances Lg, $L_s$ and $L_d$ in series with each of the gate, source and drain and a resistance $R_{gs}$ between gate and source which shorts the gate to source, in this example. When a changing voltage is applied between drain and source a current flows through the gate-drain capacitance $C_{gd}$, some of which charges the gate-source capacitance Cgs and some of which flows through $R_{gs}$ to ground. This causes a voltage spike $V_{gs}$ between gate and source which if it reaches the threshold voltage level of the MOSFET can cause the MOSFET to turn on. This effect is known as gate bounce.

It is impossible to avoid some gate bounce since it is due to the inherent capacitances in a MOSFET. However, it is possible to avoid the situation that the MOSFET turns on due to gate bounce by ensuring that the device structure and design is suitable.

The maximum voltage occurring at the gate is given by the equation:

$$V_{\max} = KC_{gd}R_{gs} + KC_{gd}\left(\frac{1}{C_{gs}} - \frac{R_{gs}^2}{4L_g}\right)\sqrt{(L_d + L_s)(C_{gd} + C_{ds})}$$

where K=dV/dt, in which V is the voltage applied to the device and t is time. This formula is taken from the PhD thesis "Optimization of Power MOSFET for High-Frequency Synchronous Buck Converter" by Yuming Bai, submitted to the faculty of the Virginia Polytechnic Institute and State University 28 August 2003, Blacksburg, Virginia, USA.

In order to prevent turn-on the maximum voltage $V_{max}$ must be less than the threshold voltage $V_T$ . As die size increases $C_{gd}$ becomes more significant which results in increased gate bounce effects. Accordingly, transistors with large die sizes are increasingly susceptible to gate bounce.

There is accordingly a need for designs of MOSFETs which minimise the effects of gate bounce.

According to the invention, there is provided a MOSFET according to claim 1.

By providing source connected trenches under the gate the gate-source capacitance $C_{gs}$ is increased.

Preferably, the MOSFET uses a deep trench isolation structure in the edge region around the active region. In this case, the same trench structure can be used for the capacitance control structure as for the trenches of the deep trench isolation which allows the two trench structures to be made in a single process greatly easing manufacture.

The semiconductor region between the trenches may be floating. In this case, the semiconductor body may couple to the drain increasing the gate-drain capacitance.

Alternatively, the semiconductor region between the trenches may be connected to the source. This further increases the gate -source capacitance $C_{gs}$ . Further, in this case the drain-source capacitance $C_{ds}$ is also increased which can reduce voltage spikes between drain and source during reverse recovery.

In another aspect, the invention relates to a method of manufacturing such a transistor as set out in claim 6.

For a better understanding of the invention, embodiments will now be described purely by way of example, with reference to the accompanying drawings, in which:

Figure 1 shows a circuit model of a MOSFET;
Figure 2 shows a top view of the semiconductor device according to the first and second embodiments;
Figure 3 shows a section through the edge region of a semiconductor device and the active region according to the first and second embodiments;
Figure 4 shows the gate-source capacitance in the edge region of the first and second embodiments and the active region;
Figure 5 shows the gate-drain capacitance in the edge region and the active region of the first embodiment; and
Figure 6 shows the drain-source capacitance in the edge region and the active region of the second embodiment.

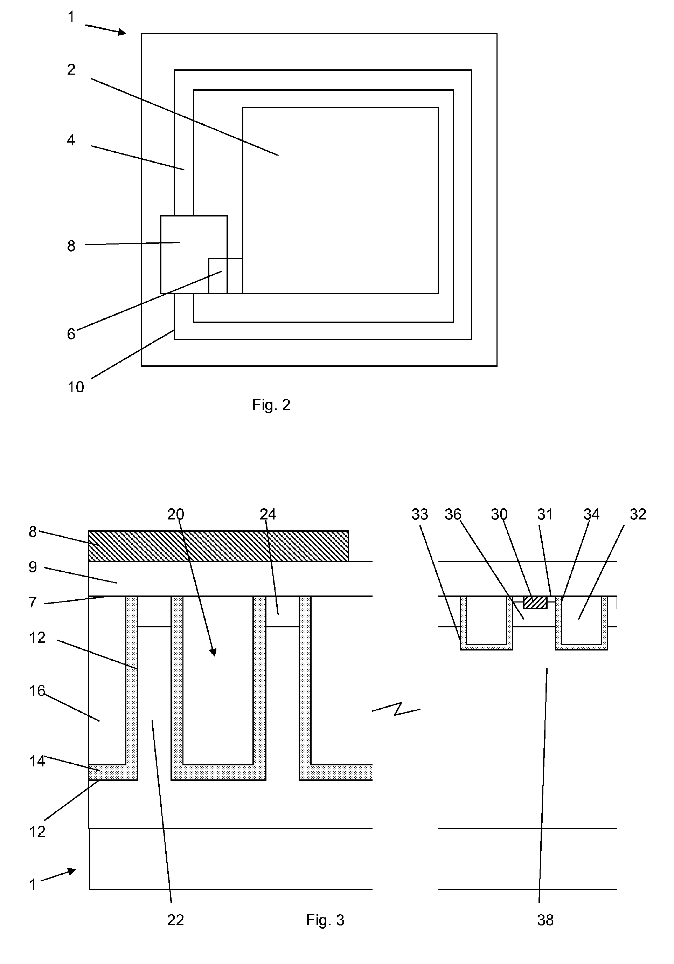

Referring to Figure 2, the semiconductor device is a MOSFET on semiconductor substrate 1 with an active region 2, an edge region 4 and a capacitance control region 6. Referring to Figure 3, the left part of this figure shows the capacitance control region 6 and the right part the transistor in the active region.

The active region 2 includes a vertical MOSFET with insulated gates 32 in trenches, insulated by thin gate insulator 34. These alternate laterally across the first major surface 7 of the substrate 1 with semiconductor regions including a source 31 adjacent to the first major surface 7 of the substrate 1. The source 31 is of a first conductivity type, in the example shown n-type. Below the source 31, i.e. away from the first major surface 7, is a semiconductor body region 36 of a second conductivity type opposite to the first conductivity type, in the example p-type. A source contact 30 runs longitudinally along the trench connecting to the source 31. The drain 38 is formed by the semiconductor region under the body 36 and is of first conductivity type, here n-type.

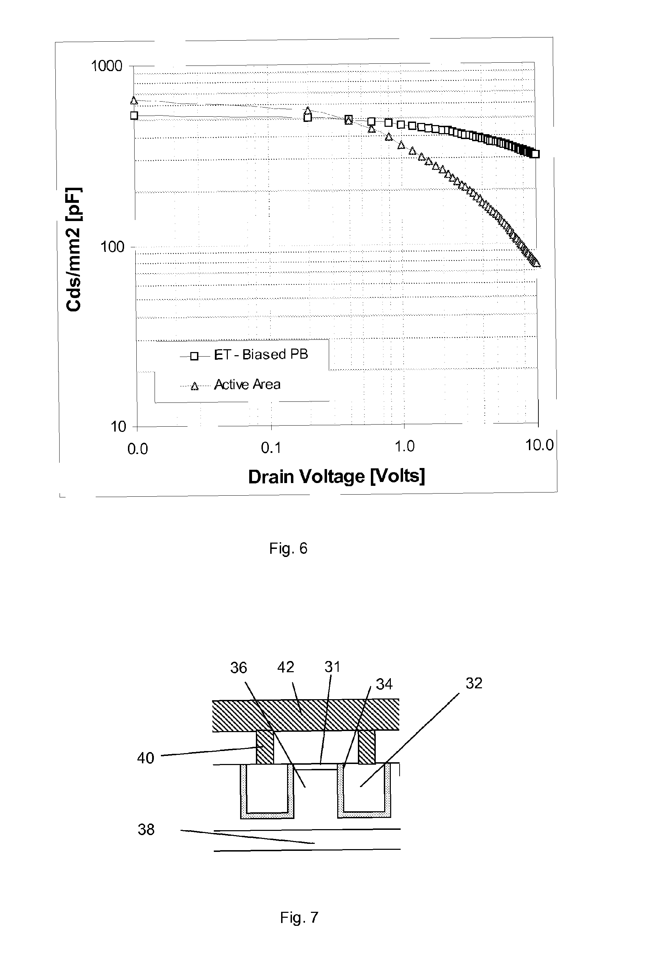

The interconnects leading to source, gate and drain are not shown, though one way of connecting to the gate is in Figure 7 and described below. Note that structures such as a low doped drain and other known structures may be used if desired.

Alternative MOSFET structures will be known to those skilled in the art and these may be adopted as an alternative. Either p-type or n-type and enhancement or depletion type MOSFETs may be manufactured. Further, the transistor may alternatively be a lateral structure.

A gate pad 8 is provided over thick insulator 9. This insulator separates the gate pad from the underlying structure which will now be described.

The capacitance control region 6 has the gate pad 8 over the insulator 9 and deep insulated trenches 12 with insulated sidewalls 14 and conductive material 16, which in this region function as capacitance control structure 20. The insulated trenches 12 in the embodiment extend into the substrate 1 from the first major surface 7 to a depth of 2 $\mu$m to 3 $\mu$m; in other embodiments the range may be 0.5 $\mu$m to 5 $\mu$m. In particular, the capacitance control structure 20 are deeper than the gate trenches 33 holding the gates 32 in the active region. The conductive material 16 in trenches 12 may be heavily doped polysilicon - the doping may be either n-type or p-type. The trenches 12 are formed in part of the semiconductor substrate 1, which will be referred to as the edge semiconductor region 22, and so viewed from above the edge semiconductor body alternates with the capacitance control structure 20. In the embodiment, this edge semiconductor region 22 is doped p-type in a surface region 24 and is lightly doped n-type below this region.

Referring back to Figure 2, deep trench isolation structures 10 surround the active region. These have the same structure as the capacitance control structure 20, i.e. a plurality of deep insulated trenches 12 with insulated sidewalls 14 and conductive material 16 filling the trenches provide an edge termination structure.

The source-connected capacitance control structure 20 of the capacitance control region 6 couple with the gate pad 8 to provide additional source-gate capacitance $C_{gs}$.

In a first embodiment, the surface region 24 is floating, not connected to source or drain. In this first embodiment the floating conductive material couples to the gate and to the drain (below) so that additional of gate-drain capacitance $C_{gs}$ is provided because of the coupling between the conductive material 16 of the capacitance control structure 20 and the edge semiconductor body 22 across the insulated sidewalls of the trenches 22.

In a second embodiment, the surface region 24 is connected to the source 31 by a contact. This provides an additional source-drain capacitance by virtue of the coupling between the floating region 24 and the gate pad 8 through insulator 9. Those skilled in the art will be able to adjust the size of the capacitance control region, i.e. the area of the region with capacitance control structure 20 under the gate pad 8, to select suitable capacitances to minimise gate bounce.

In more detail, an open or floating gate will couple to the drain by a capacitance ratio given by

$$V_{gs} = V_{ds}\, C_{gd}\, /(C_{gs} + C_{gd}).$$

which is an equation relating the gate -source voltage $V_{gs}$ and the drain source voltage $V_{ds}$.

The value of $V_{ds}$ for which $V_{gs}$ equals the threshold voltage $V_{gstx}$ can then be determined and will be referred to as $BV_{dso}$. To avoid risk of gate bounce, the value of $BV_{dso}$ at which this takes place should exceed 10V.

It will be noted that increasing $C_{gs}$ for fixed $C_{gd}$ increases $BV_{dso}$ and this increase in $C_{gs}$ is achieved using the invention by the source connected capacitance control structure 20 underlying the gate pad 8, as well as the source connected edge semiconductor body region 22 in the second embodiment.

Alternative ways of increasing $C_{gs}$ have disadvantages. One possibility would be to increase the channel length, but this also increases the channel resistance. Another possibility is to use thinner gate oxide, but the ability to reduce oxide thickness is limited by the maximum gate voltage requirement of the device.

A further possibility would be to increase the threshold voltage itself. This is a preferred method but does lead to a higher on resistance which can be detrimental.

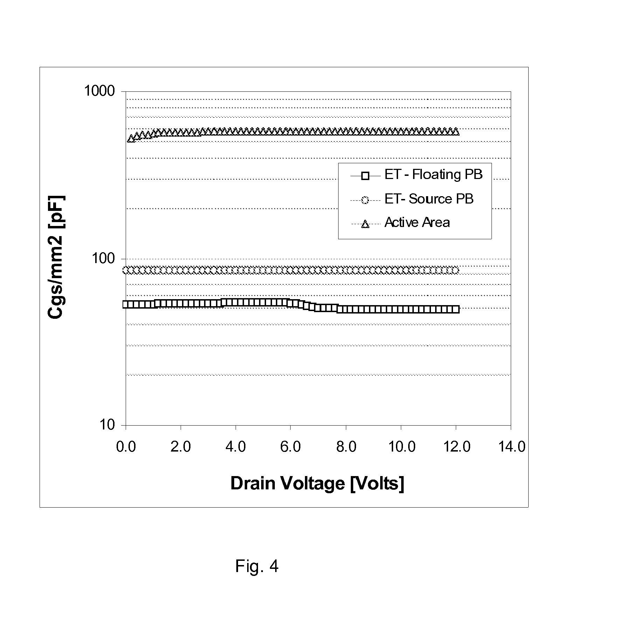

Calculations of the increased capacitance achieved using the invention have been carried out and are shown in Figures 4 to 6.

Figure 4 shows the gate-source capacitance $C_{gs}$ from the active area (triangles), and from the capacitance control region for the first embodiment (squares) and the second embodiment (circles). The increased gate-source capacitance from the second embodiment may be seen. Note that the capacitances are shown for unit area as a function of drain voltage.

In summary, the active area has a gate-source capacitance of around 550 pF/mm$^2$, and the capacitance control region has a gate source capacitance of 50 pF/mm$^2$ in the first embodiment and 85 pF/mm$^2$ in the second embodiment.

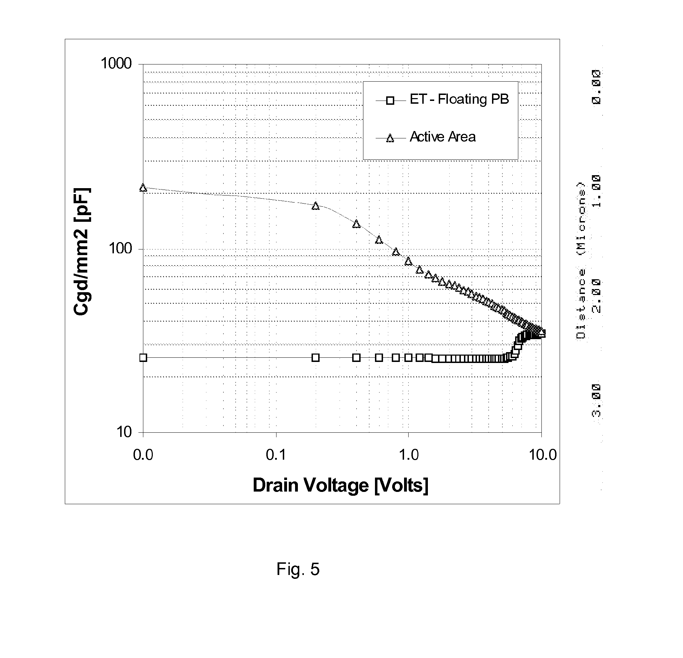

Figure 5 shows the gate-drain capacitance in the first embodiment in which the edge semiconductor body region 22 floats, in the active area (triangles) and in the capacitance control region (squares).

In summary, at a drain voltage of 0V, the active area delivers about 216 pF/mm$^2$ and the capacitance control region 26 pF/mm$^2$.

Figure 6 shows the drain-source capacitance in the second embodiment with a source-connected edge semiconductor body region 22 in the active area (triangles) and in the capacitance control region (squares).

Typically, by way of example, the capacitance control region 6 is sized to deliver a total gate-source capacitance of 2% to 20%, preferably 5% to 10% of the total gate-source capacitance. Although this may seem to be a small improvement, the way this is achieved gives an important additional benefit - the drain-source capacitance $C_{ds}$ is much more constant in the capacitance control region than in the active area and this results in a more constant total drain-source capacitance $C_{ds}$ for the complete device. This in turn reduces the spike in voltage so that the chance of gate bounce is further reduced as a result of this effect.

Thus, the embodiment described delivers a significant improvement in gate bounce properties without taking up much additional area.

To summarise the calculated results of Figure 6, at a drain voltage of 0V, the active area delivers a drain -source capacitance of 649 pF/mm$^2$ and the capacitance control region 528 pF/mm$^2$.

Alternative and additional implementations of the invention are possible.

One approach is to provide the gate pad 8 in a different part of the semiconductor device, not in a separate edge region. In this approach, illustrated in Figure 7, the p-type body region 36 in part of the active region is extended to be below the gates 32. This region of the trench omits the source contact but instead is used to provide an electrical connection to the gates 32 by connecting the gate 32 to gate metallisation 42 through via connection 40. In this region, the source contact 30 is omitted. This region has accordingly a reduced gate-drain capacitance, since the drain 38 (below the body 36) is no longer adjacent to the gate, but instead provides additional source-drain capacitance between the source 31 and the gate metallisation 42. The gate metallisation 42 is simply an extension of the gate pad 8.

In preferred approaches with a plurality of gate trenches 33 in the active area, the arrangement of Figure 7 with the deeper p-type body region 36 is used at the ends of each of the gates 32, additionally to the additional capacitance in the edge region obtained with the arrangement of Figures 2 and 3.

In an alternative arrangement, the gates 32 do not fill the trenches at the ends of the gate trenches 33 and the semiconductor body 36 extends below the depth of the gate 32 but not below the depth of the trenches.

It will be appreciated that various alternative embodiments are possible. For example, although the term "substrate" is used, this is to be interpreted broadly as including semiconductor devices with epitaxial layers thereon.

**Claims**

1. A Metal Oxide Semiconductor Field Effect Transistor, MOSFET, comprising:

    a semiconductor substrate (1);
    an active region of the semiconductor substrate (1) having a FET with gate (32), source (31) and drain (38);
    further comprising a capacitance control region (6) having a gate pad (8) over the semiconductor substrate (1), the gate pad (8) being electrically connected to the gate (32) and a plurality of control structures (20) extending into the semiconductor substrate (1), the control structures (20) being trenches (12) insulated by insulator (14) and containing conductor (16) extending under the gate pad (8) from the active region, the conductor (16) being electrically connected to the source (31) for providing capacitance between the source (31) and the gate (32).

2. A MOSFET according to claim 1, further comprising a deep trench isolation structure extending around the active region (2) in the edge region (4), the deep trench isolation structure including a plurality of isolation trenches (10), wherein the isolation trenches (10) have the same depth, contain the same insulation material (14) and contain the same conductor (16) as the control structures (20).

3. A MOSFET according to claim 1 or 2, wherein the FET is a vertical Trench FET having the gate (32) in a plurality of gate trenches (33) alternating laterally with semiconductor regions across a first major surface of the substrate, the trenches extending into the substrate (1) from the first major surface (7) and also extending longitudinally across the first major surface (7), the source (31) being a region of first conductivity type provided adjacent to the first major surface (7) above a body region (36) of a second conductivity type opposite to the first conductivity type above the drain (38) of first conductivity type.

4. A MOSFET according to claim 3 wherein at the longitudinal ends of the gate trenches (33) the semiconductor body (36) of second conductivity type extends below the depth of the gate (32).

5. A MOSFET according to claim 4 wherein a gate metallisation (42) extends above the longitudinal ends of the gate trenches (33) and is connected to the gates (32) in the gate trenches (33) by via connections (40).

6. A MOSFET according to any preceding claim, wherein the semiconductor body (22) in the capacitance control region (6) between the control structures (20) is floating.

7. A MOSFET according to any of claims 1 to 5, wherein the semiconductor body (22) in the capacitance control region (6) between the control structures (20) is connected to the source.

8. A MOSFET according to any preceding claim, wherein the gate-source capacitance in the capacitance control region between the gate pad (8) and the capacitance control structure (20) is 2% to 20%, preferably 5% to 10%, of the total gate-source capacitance of the MOSFET.

9. A method of manufacturing a MOSFET according to any preceding claim, the method comprising:

providing a semiconductor substrate (1);
forming gate (32) , source (31) and drain (38) in an active region (2);
etching a plurality of trenches (12) into a semiconductor body region;
insulating the plurality of trenches (12) with insulator (14);
filling the trenches with conductor (16) to form a control structure (20) and connecting the conductor (16) to the source (31);
depositing insulator (9) over the trenches; and
forming a gate pad (8) over the insulator (9) over the control structure (20) for providing additional capacitance between the source and the gate.

10. A method according to claim 9, wherein the step of etching a plurality of trenches (12) further comprises forming some of the trenches (12) as deep trench isolation trenches (10) around the active region (2).

Fig. 1

1

2

4

8

6

10

Fig. 2

8

20    24

33   36   30   31   34   32

9

7

12

16

14

12

1

22    Fig. 3    38

Fig. 4

Fig. 5

Fig. 6

Fig. 7

Europäisches
Patentamt

European
Patent Office

Office européen
des brevets

# EUROPEAN SEARCH REPORT

**Application Number**

EP 10 17 2930

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/140695 A1 (YEDINAK J A ET AL) 10 June 2010 (2010-06-10) * paragraph [0057] - paragraph [0063]; figures 32-34 * * paragraph [0066] - paragraph [0067]; figure 36 * ----- | 1-10 | INV. H01L29/78 H01L29/40 ADD. H01L29/06 H01L29/10 |
| X | US 2010/123220 A1 (BURKE P A ET AL) 20 May 2010 (2010-05-20) * paragraph [0063] - paragraph [0065]; figures 20-22 * * figures 1,2,4-16 * * paragraph [0067]; figure 24 * ----- | 1-10 | |
| A | WO 2005/065385 A2 (FAIRCHILD SEMICONDUCTOR CORP ET AL) 21 July 2005 (2005-07-21) * paragraph [0146] - paragraph [0147]; figures 25F,26A * ----- | 2,10 | |
| A | WO 2009/057015 A1 (NXP BV ET AL) 7 May 2009 (2009-05-07) * page 6, line 27 - page 7, line 16; figures 3,4 * * page 9, line 8 - page 10, line 7; figure 10 * ----- | 4,5 | TECHNICAL FIELDS SEARCHED (IPC) H01L |

The present search report has been drawn up for all claims

| Place of search | Date of completion of the search | Examiner |
|---|---|---|
| Munich | 2 February 2011 | Morvan, Denis |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 10 17 2930

This annex lists the patent family members relating to the patent documents cited in the above-mentioned European search report.
The members are as contained in the European Patent Office EDP file on
The European Patent Office is in no way liable for these particulars which are merely given for the purpose of information.

02-02-2011

| Patent document cited in search report | | Publication date | Patent family member(s) | | Publication date |
|---|---|---|---|---|---|
| US 2010140695 | A1 | 10-06-2010 | WO | 2010077510 A2 | 08-07-2010 |
| US 2010123220 | A1 | 20-05-2010 | CN | 101740622 A | 16-06-2010 |
| WO 2005065385 | A2 | 21-07-2005 | CN | 101794817 A | 04-08-2010 |
| | | | DE | 112004002608 T5 | 16-11-2006 |
| | | | DE | 202004021352 U1 | 16-08-2007 |
| | | | JP | 2007529115 T | 18-10-2007 |
| | | | JP | 2008227514 A | 25-09-2008 |
| WO 2009057015 | A1 | 07-05-2009 | EP | 2206154 A1 | 14-07-2010 |
| | | | US | 2010320532 A1 | 23-12-2010 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **YUMING BAI.** Optimization of Power MOSFET for High-Frequency Synchronous Buck Converter. Virginia Polytechnic Institute and State University, 28 August 2003